# EUROPEAN PATENT APPLICATION

(11) **EP 1 605 493 A1**
(43) Date of publication of application: **14.12.2005**
(21) Application number: 04405352.8
(22) Date of filing: 07.06.2004
(51) Int. Cl.: H01J 37/32

(54) **Plasma processing control**

(71) Applicant: HELYSSEN S.à.r.l., 1006 Lausanne (CH)
(72) Inventor: Guittienne, Philippe, 1006 Lausanne (CH)
(74) Representative: Besse, François

(57) **Abstract**

A plasma processing control and apparatus uses Nuclear Magnetic Resonance to characterize the process chamber and workpieces inside. This method is suitable for plasma sterilization where microbial life must be destroyed.

## Description

### FIELD OF INVENTION

The present invention relates to a method and apparatus to control any plasma processing.

### BACKGROUND OF THE INVENTION

The use of nuclear magnetic resonance for physical, chemical and biological studies is very well developed and highly successful (P.J. Hore, Nuclear Magnetic Resonance, Oxford University Press, Oxford, UK, 1995 ; R.J. Abraham, J. Fisher and P. Loftus, Inroduction to NMR spectroscopy, Wiley, Chichster, UK, 1988).

In a conventional pulsed Nuclear Magnetic Resonance (NMR) Measurement, the sample is placed in a highly uniform magnetic field of typically B<10T and an Radiofrequency (RF) coil outside the sample applies a pulse of oscillating magnetic field B1 transverse to B. This B1 pulse rotates the nuclear spins from their equilibrium direction along B to a transient state with their net spins aligned transverse to B. After the driving RF field is turned off, these spins then begin to precess about B at the NMR frequency and produce a transverse magnetic field .The relaxation of these spins back to equilibrium, can be measured with a RF antenna (J. Jin, Electromagnetic Analysis and Design in Magnetic Resonance Imaging, CRC Press, 1999).

In plasma physics, there have been some attempts to use the NMR to measure the properties of plasmas (S.J. Zweben, & al., Rev. Sci. Inst., 74, 2003) in tokamak experiments.

There are several properties of plasmas which make NMR measurements more difficult than those on solids or liquids, for example : Low density, High temperature, non uniform B field, complexity of RF wave propagation.

In industrial plasma processing, a lot of diagnostic techniques are available (mass spectroscopy, optical emission spectroscopy, Langmuir probes...) to monitor and control the process, on one hand, at the workpiece level (quality) and, on the other hand, at the chamber level (the gas interact with the walls of the chamber and can shift the operational process parameters).

### SUMMARY OF THE INVENTION

In situ Monitoring and Metrology in plasma processing improve both the process quality, and the manufacturing : a quantitative knowledge of the major parameters and the characterization of the workpieces, on one hand, allow the optimization of the process recipies (pressure, flowrate, RF power,...), and the yield of manufacturing by the characterization of the process environment, and, on the other hand, by an in situ approach, don't interact with the workpieces, preventing any damage. NMR techniques in plasma process chamber can be used for example to characterize the workpieces before and after the plasma process (temperature mapping...), validate the chamber after cleaning (In situ moisture monitoring...). These in situ NMR techniques have heretofore not been used for such plasma processing.

The innovation is first based on the integration : the footprint of a process equipment including NMR diagnostics is typically twice less than the one of a process equipment and a metrology equipment. Secondly, in order that processes and NMR techniques are operationally compatible, the materials used in the process chamber must be specific (in particular non magnetic...). Thirdly, the pulse generated and received by the NMR coils are designed - in term of duration, amplitude, periode - according to the nature of the workpieces, and materials which need to be monitored during or before and after the process.

The present invention uses a process chamber coupled to one or a plurality of plasma sources. In the proximity of the process chamber are placed magnets and RF coils to perform NMR spectroscopy and/or Magnetic Resonance Imaging inside the said process chamber. These same components can be used for an active control of the plasma (profile, rotation...) in order to improve the interactions of the plasma with the workpieces.

The present invention is suitable for plasma sterilization where the ionized gas will contact microorganisms on the surfaces of the workpieces to be sterilized and effectively destroy the microorganisms. The control of residuals by NMR can be performed in situ, for example, as a specific step during the sterilization process.

### BRIEF DESCRIPTION OF THE DRAWING

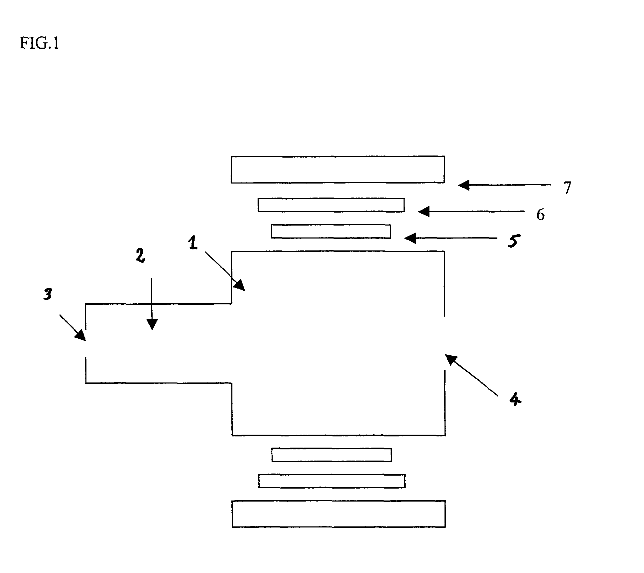

FIG. 1 shows a schematic drawing of the plasma chamber used in the present invention .

### DETAILED DESCRIPTION

Plasmas are normally generated by electrical discharges in gases. Plasmas generated at atmospheric pressure or at higher pressures are called "arcs" or high temperature plasma and may involve temperatures in excess of 1000°C. Plasmas generated at reduced pressures, i.e. 10-3 to 102 Torr, are call "glow discharge" or low temperature plasma and involve temperatures of a few tenths to a few hundred degrees Centigrade. The low temperature plasma is preferably generated at pressures of less than 10 Torr and generally involves temperatures of less than 100 °C.

When used in the present invention, the term "plasma" is intended to include any portion of the gas or vapors which contains electrons, ions, free radicals, dissociated and/or excited atoms or molecules produced as a result of the applied electromagnetic field including any accompanying radiation which might be produced. The applied field may cover a broad frequency range, however, a radio frequency is commonly used.

In the present invention, the plasma source coupled to the process chamber can be RF discharge type, microwave discharge type, Direct Current discharge type or beam discharge type.The pressure inside the process chamber can be from high vacuum level to atmospheric level.

The RF energy used to generate the plasma may be continuous or it may be pulsed. The plasma may be pulsed while maintaining the pressure of the plasma constant. The use of a pulsed plasma prevents the overheating of the gas within the chamber as well as preventing the overheating of processed workpieces.

Any type of gas can be injected either in the plasma source, either in the plasma source and in the process chamber. NMR measurements in presence of plasma are facilitated if spin polarized gas , like Hydrogen or Helium, are used to fuel the plasma.

Moreover, one or a plurality of laser beams at the right wavelength (according to the nature of gas) allow to enhance the gas polarization.

The workpieces or their loader inside the process chamber can be submitted to bias voltage in order to improve plasma - workpiece(s) interactions.

The present invention is well adapted to plasma sterilization. The use of plasma to sterilize objects was suggested in U.S. Pat. No. 3,383,163. The ionized gas will contact microorganisms on the surfaces of the objects to be sterilized and effectively destroy the microorganisms. No in-situ monitoring exists to validate or control the efficency of the process. What we propose is to use components which a part is already present in the proximity of the process chamber to perform Nuclear Magnetic Resonance spectroscopy and/or Magnetic Resonance Imaging of objects , in order especially to measure the residual microbial life. This approach can significantly improve the quality and yield of the process.

Plasma processing is usually carried out in a chamber 1 as illustrated in FIG.1. The chamber includes an opening through which workpieces can be introduced. The chamber also includes one or a plurality of communications with one or a plurality of plasma sources 2 .The gas or vaporized liquids are injected in the plasma source through ports 3, and are evacuated in the downstream line which the interface with the process chamber is represented in 4.

Magnets 7 are placed in the proximity of the process chamber and can be used for the confinement of plasma inside the chamber. In all NMR systems, it is necessary to generate a strong magnetic field which is uniform over the volume of interest. Even when field gradients are desired, a main magnet is used to generate a primary field while gradient RF coils 6 create a gradient which is superimposed upon the main field. Depending upon the application, permanent, resistive, or superconducting magnets may be used. Permanent magnets offer the advantages of simplicity and affordability. Gradient fields can be produced in any of the three spatial directions without physically rotating the gradient coils.

In all NMR, it is necessary to excite the nuclei into coherent precession. This requires coupling between the nuclei and some source of RF power (the transmitter). To receive a meaningful signal, one also needs a device to couple the nuclei to some external circuitry. These devices are called RF coils 5. The coils may be solenoidal or from any open or closed shape. It is also desirable to have a coil which permits "quadrature" excitation and detection. Electromagnetically, this is equivalent to being able to generate and receive circularly polarized fields. A circuit is needed to split equally the transmitting power into two channels and introduce a 90° phase delay in one of the channels. These two channels are then fed to the two inputs of the RF coil to produce two fields perpendicular to each other. For receiving, a circuit is also needed to introduce a 90° phase delay in one of the two input signals so that both signals are in phase and can be combine coherently.

To convert the received RF signal from the RF coils 5 into a form suitable for an analog-to-digital converter or digitizer .

## Claims

1. An arrangement comprising :
- a process chamber coupled to at least one plasma source,
- a magnet,
- a coil,
- a workpiece,
**characterized by** the fact that it furthermore comprises NMR means adapted to perform NMR spectroscopy and/or Magnetic Resonance Imaging inside the said process chamber.

2. Arrangement according to claim 1 wherein said magnet(s) and said coil(s) also constitute parts of said NMR means.

3. Arrangement according to any of the previous claims wherein said plasma source contains at least one antenna connected to at least one RF generator.

4. Arrangement according to any of the previous claims wherein said plasma source contains at least one microwave source.

5. Arrangement according to any of the previous claims wherein said plasma source contains at least one electrode.

6. Arrangement according to any of the previous claims wherein a part of said coil(s) is adapted to generate gradient field.

7. Arrangement according to claim 6 wherein at least one transmitter is connected to the coil(s) and is adapted to generate pulses (in term of shape,duration,power and timing), said RF coil(s) being responsible for coupling the energy generated by the transmitter to the nuclei of the workpiece(s) or the nuclei of process chamber walls.

8. Arrangement according to the claim 7 wherein at least one receiver is connected to the coil(s) in such a way as to convert the received RF signal from the coil(s) into a form suitable for an analog-to-digital converter or digitizer.

9. Arrangement according to any of the previous claims wherein biased electrodes are placed in the proximity of said process chamber in order to make an active control of plasma such as plasma profile, plasma rotation...

10. Arrangement according to any of the previous claims containing means to inject in the process chamber gas like spin polarized gas (such as Hydrogen or Helium) or vaporized liquids.

11. Use of an arrangement according to any of the previous claims for plasma sterilization applications.
